# EUROPÄISCHE PATENTSCHRIFT

(11) **EP 3 970 256 B1**
(45) Veröffentlichungstag und Bekanntmachung des Hinweises auf die Patenterteilung: **02.12.2026**
(21) Anmeldenummer: 20745183.2
(22) Anmeldetag: 23.07.2020
(51) Int. Cl.: H02J 7/00, B60L 53/67, G01R 31/00, B60S 1/02

(54) **VERFAHREN ZUM WARTEN VON FAHRZEUGKOMPONENTEN UNTER VERWENDUNG EINES NETZWERKSERVERS**
METHOD FOR SERVICING VEHICLE COMPONENTS USING A NETWORK SERVER
PROCÉDÉ D'ENTRETIEN DE COMPOSANTS DE VÉHICULE À L'AIDE D'UN SERVEUR RÉSEAU

(30) Priorität: 26.07.2019 DE 102019211154
(43) Veröffentlichungstag der Anmeldung: 23.03.2022
(73) Patentinhaber: VOLKSWAGEN AKTIENGESELLSCHAFT, 38440 Wolfsburg (DE)
(72) Erfinder: FRIEDERICH, Marco, 38104 Braunschweig (DE); DÖRING, Martin, 38124 Braunschweig (DE)
(86) Internationale Anmeldenummer: PCT/EP2020/070748
(87) Internationale Veröffentlichungsnummer: WO 2021/018710

(56) Entgegenhaltungen:
- EP-A1- 2 775 457
- WO-A2-01/15001
- DE-A1- 102016 224 193

## Beschreibung

Die Erfindung betrifft ein Verfahren eines Netzwerkservers zum Warten von Fahrzeugkomponenten, insbesondere zum Fernwarten von Fahrzeugkomponenten basierend auf einer Überwachung der Leistungsaufnahme der Fahrzeugkomponenten einer Vielzahl von Fahrzeugen. Die Erfindung betrifft ferner einen zum Durchführen des erfindungsgemäßen Verfahrens eingerichteten Netzwerkserver, ein zum Beteiligen am erfindungsgemäßen Verfahren eingerichtetes Kraftfahrzeug und ein System aus Netzwerkserver und Kraftfahrzeug.

Moderne Fahrzeuge verfügen über eine Vielzahl elektronisch gesteuerter Fahrzeugkomponenten, die regelmäßig von Steuergeräten geregelt und überwacht werden. Mittels der Überwachung der Komponenten sollen insbesondere unsichere Zustände derselben detektiert beziehungsweise verhindert werden. Das Überwachen der Fahrzeugkomponenten setzt somit stets eine Definition dieser unsicheren Betriebszustände beziehungsweise diese anzeigende Parameter voraus. Häufig geschieht dies mittels der Definition von Grenzwerten.

Während des Betriebs des Fahrzeugs können sich jedoch die Eigenschaften der Fahrzeugkomponenten, beispielsweise alterungsbedingt, ändern. Ebenso können sich die Einsatzbedingungen des Fahrzeugs und somit auch die der Fahrzeugkomponenten ändern. Das Überwachen der Fahrzeugkomponenten basierend auf vordefinierten Grenzwerten kann so zur Fehldiagnose oder zur fehlenden Erkennung unsicherer Betriebszustände führen.

Aus dem Stand der Technik sind bereits Verfahren bekannt, mit denen zumindest der Einfluss wechselnder Umweltbedingungen bei der Überwachung von Fahrzeugkomponenten berücksichtigt werden kann. So beschreibt die WO 2004/024531 A1 ein Verfahren, bei dem ein Fahrzeug sowohl Sensoren zum Erzeugen von Komponentendaten bezüglich überwachter Fahrzeugkomponenten als auch Sensoren zum Erzeugen von Umgebungsdaten aufweist. Sowohl die Komponentendaten als auch die Umgebungsdaten werden weiterverarbeitet.

Die WO 01/15001 A2 offenbart ein Verfahren zur Überwachung einer Flotte von beispielsweise Fahrzeugen. Dabei können Fahrzeuge derart überwacht werden, dass vorausgesagt werden kann, ob dem Fahrzeug kurzfristig ein Ausfall droht.

Die EP 2 775 457 A1 zeigt ein System zur Überwachung des Zustands von elektrischer Energieerzeugung und -verteilung. Das System umfasst ein Netzwerk aus einer Vielzahl von Knoten in einem elektrischen System eines Fahrzeugs. Jeder Knoten aus der Vielzahl von Knoten ist mit anderen Knoten aus der Vielzahl von Knoten synchronisiert. Das Netzwerk ist so konfiguriert, dass es dem elektrischen System zugeordnete Zustandsdaten des elektrischen Systems an mindestens ein Fahrzeugzustandsberichtssystem übermittelt. Bei dem Fahrzeug kann es sich um ein Flugzeug handeln.

Die aus dem Stand der Technik bekannte Lösung erfordert somit neben den Sensoren für die zu überwachenden Komponenten weitere Sensoren, die der Überwachung von Umgebungsparametern dienen. Dies erfordert zusätzlichen Bauraum und verursacht Kosten.

Der Erfindung liegt daher die Aufgabe zugrunde, den Stand der Technik zu bereichern und ein alternatives Verfahren zum Warten von Fahrzeugkomponenten zur Verfügung zu stellen, das situativ und adaptiv fehlerhafte Betriebszustände einer Vielzahl von Kraftfahrzeugen detektiert.

Die erfindungsgemäße Aufgabe wird gelöst durch die Gegenstände der Hauptansprüche. Bevorzugte Weiterbildungen sind Gegenstand der jeweils rückbezogenen Unteransprüche.

Ein Aspekt der vorliegenden Erfindung betrifft ein Verfahren eines Netzwerkservers zum Warten von Fahrzeugkomponenten. Wie im Folgenden noch im Detail erläutert, handelt es sich bei dem Netzwerkserver vorzugsweise um einen Netzwerkserver eines Fahrzeugherstellers oder eines mit diesem verbundenen Servicepartners. Der Netzwerkserver ist ferner zur Kommunikation mit einer Vielzahl von Fahrzeugen eingerichtet, insbesondere über eine Luftschnittstelle, und weist hierfür ein entsprechend ausgebildetes Kommunikationsmodul auf. Der Netzwerkserver weist ferner eine Steuereinheit auf, die zum Durchführen von Datenverarbeitung ausgebildet ist.

Das erfindungsgemäße Verfahren des Netzwerkservers weist in einer einfachsten Form die folgenden Verfahrensschritte auf. In einem ersten Schritt empfängt der Netzwerkserver Datensätze von einer Mehrzahl von Fahrzeugen, wobei jeder Datensatz die Leistungsaufnahme von Fahrzeugkomponenten eines der Mehrzahl von Fahrzeugen betrifft. Die Leistungsaufnahme kann dabei durch eine Spannungs- und/oder Stromaufnahme der jeweiligen Fahrzeugkomponente gekennzeichnet sein. Jeder Datensatz weist dabei bevorzugt Daten zur Leistungsaufnahme einer Mehrzahl von Fahrzeugkomponenten des Fahrzeugs auf.

In einem weiteren Schritt des erfindungsgemäßen Verfahrens erfolgt ein Auslesen der Daten zur Leistungsaufnahme einer Fahrzeugkomponente aus einer Mehrzahl der empfangenen Datensätze. Mit anderen Worten werden Daten zur Leistungsaufnahme einer bestimmten Fahrzeugkomponente beziehungsweise eines bestimmten Typs von Fahrzeugkomponenten aus mehreren der empfangenen Datensätze extrahiert. Die ausgelesenen Daten betreffen somit die Leistungsaufnahme der gleichen Fahrzeugkomponenten in verschiedenen Fahrzeugen. Die Daten werden dabei aus allen oder zumindest einigen der empfangenen Datensätze extrahiert.

Im erfindungsgemäßen Verfahren erfolgt ferner ein Ermitteln einer abweichenden Leistungsaufnahme der Fahrzeugkomponenten in zumindest einem Fahrzeug basierend auf den ausgelesen Daten. Mit anderen Worten wird anhand der Informationen zur Leistungsaufnahme der gleichen Fahrzeugkomponente in verschiedenen Fahrzeugen zumindest eine Leistungsaufnahme ermittelt, die auf unzulässige Weise von den anderen Leistungsaufnahmen der gleichen Fahrzeugkomponente abweicht. Mit anderen Worten wird mittels einer statistischen Auswertung der ausgelesenen Daten zumindest eine Fahrzeugkomponente ermittelt, deren Leistungsaufnahme auf einen unzulässigen beziehungsweise unsicheren Betriebszustand hinweist. Die statistische Auswertung basiert dabei beispielsweise auf dem Bilden eines arithmetischen Mittels, eines Medians oder dergleichen der ausgelesenen Daten zur Leistungsaufnahme der gleichen Fahrzeugkomponente in verschiedenen Fahrzeugen.

Im erfindungsgemäßen Verfahren erfolgt ferner eine Ausgabe einer Fehlermeldung bezüglich der Fahrzeugkomponente in dem zumindest einen Fahrzeug, zu der eine abweichende Leistungsaufnahme ermittelt worden ist. Mit anderen Worten wird die ermittelte abweichende Leistungsaufnahme in einer von dem Netzwerkserver ausgegebenen Fehlermeldung adressiert. Die Fehlermeldung ist dabei an das Fahrzeug, einen Nutzer des Fahrzeugs oder einen Hersteller des Fahrzeugs oder Servicepartner desselben adressiert. Je nach Adressat der Fehlermeldung wird diese auf verschiedene Weise weiterverarbeitet, wie noch beschrieben.

Das erfindungsgemäße Verfahren ermöglicht vorteilhaft das Erkennen und Detektieren von unzulässigen, unsicheren beziehungsweise fehlerhaften Zuständen von Fahrzeugkomponenten anhand der Überwachung der Leistungsaufnahme der Fahrzeugkomponenten. Durch Bilden eines Schwarmmittels der Leistungsaufnahme einer bestimmten Fahrzeugkomponente über eine Fahrzeugflotte erfolgt vorteilhaft eine automatische Adaption der Fehlererkennung, die sowohl alterungsbedingte Zustandsänderungen der Fahrzeugkomponenten als auch verschiedene Umgebungsbedingungen berücksichtigen kann. Beispielsweise wird eine Änderung der Umgebungsbedingungen, wie ein Absinken der Außentemperatur im Winter, in dem berücksichtigten Schwarmmittel der Leistungsaufnahme automatisch abgebildet. Somit wird selbst bei der Vorgabe fester Abweichungsgrenzwerte adaptiv auf Veränderungen reagiert. Ebenso können alterungsbedingte Zustandsänderungen berücksichtigt werden, gegebenenfalls unter Heranziehung weiterer Daten wie im Folgenden noch im Detail beschrieben wird.

In einer bevorzugten Durchführungsform des erfindungsgemäßen Verfahrens basiert jeder Datensatz auf Daten zumindest einer in einem der Fahrzeuge verbauten Stromverteilereinheit (ePDU - electronic Power Distribution UNIT). Derartige Stromverteilereinheiten basieren auf Halbleiter-Sicherungen und werden zunehmend in Bordnetzen von Fahrzeugen eingesetzt, um lokal deren Mehrwertfunktionen zu nutzen. Gemäß dieser bevorzugten Durchführungsform werden die ePDUs mit einer Fernwartungsfunktion ausgestattet, indem durch diese erfasste Daten zur Leistungsaufnahme von Fahrzeugkomponenten zur Weiterverarbeitung von einem Netzwerkserver empfangen werden. Indem eine Mehrzahl von Fahrzeugen Datensätze zur Leistungsaufnahme an den Netzwerkserver übermittelt, können gleichartige Fahrzeugkomponenten vorteilhaft miteinander verglichen werden. Insbesondere sind durch eine Analyse solcher Schwarmdaten vorteilhaft Abweichungen von einem Ist-Zustand detektierbar.

In einer ferner bevorzugten Durchführungsform umfasst das erfindungsgemäße Verfahren den weiteren Verfahrensschritt, dass anhand der aus einer Vielzahl empfangener Datensätze zu einer bestimmten Fahrzeugkomponente in einer Vielzahl von Fahrzeugen ausgelesenen Daten eine mittlere Leistungsaufnahme der bestimmten Fahrzeugkomponente ermittelt wird. Diese mittlere Leistungsaufnahme wird dabei bevorzugt als arithmetisches Mittel oder als Median der ausgelesenen Daten ermittelt. Gemäß dieser Durchführungsform wird eine abweichende Leistungsaufnahme ermittelt, wenn die Leistungsaufnahme der bestimmten Fahrzeugkomponente in einem Fahrzeug um mehr als einen vorbestimmten Grenzwert von der ermittelten mittleren Leistungsaufnahme abweicht. Diese Durchführungsform ermöglicht vorteilhaft eine besonders einfache Implementierung des erfindungsgemäßen Verfahrens.

In einer ebenfalls bevorzugten Durchführungsform des erfindungsgemäßen Verfahrens erfolgt das Auslesen der Daten zur Leistungsaufnahme einer Fahrzeugkomponente aus von Fahrzeugen eines gleichen Fahrzeugtyps empfangenen Datensätzen, besonders bevorzugt ausschließlich aus von Fahrzeugen eines gleichen Fahrzeugtyps empfangenen Datensätzen. Somit wird sichergestellt, dass eine Annahme einer prinzipiell gleichen Leistungsaufnahme der jeweiligen Fahrzeugkomponente, wie beispielsweise einer Heckscheibenheizung, einem Scheibenwischer, einer Sitzheizung, einer Klimaanlage etc., möglichst zutreffend ist. Ferner bevorzugt werden im erfindungsgemäßen Verfahren nur Daten aus den Datensätzen ausgelesen, die zu Fahrzeugkomponenten mit einer bestimmten, insbesondere gleichen, Bauteilenummer korrespondieren. So kann die Annahme einer prinzipiell gleichen Leistungsaufnahme ebenfalls sichergestellt werden. Ebenfalls bevorzugt werden nur solche Daten ausgelesen, die zu Fahrzeugkomponenten gleicher Chargennummer korrespondieren. Somit wird vorteilhaft sogar eine Verfälschung des Schwarmmittels aufgrund produktionsbedingter Schwankungen zwischen verschiedenen Baureihen vermieden.

In einer ebenfalls bevorzugten Durchführungsform des erfindungsgemäßen Verfahrens wird ferner die abweichende Leistungsaufnahme der Fahrzeugkomponenten in dem zumindest einen Fahrzeug neben den ausgelesenen Daten zusätzlich anhand weiterer, von den zu der Mehrzahl empfangener Datensätze korrespondierenden Fahrzeugen empfangener Daten ermittelt. Wie bereits vorstehend erläutert können Daten zur Gleichartigkeit von Fahrzeugkomponenten bereits bei der Auswahl der auszulesenden Datensätze berücksichtigt werden. Weitere Daten, wie beispielsweise zur Bauteile- oder Chargennummer der Fahrzeugkomponenten können jedoch auch in der weiteren Analyse der ausgelesenen Daten berücksichtigt werden. Dies ermöglicht vorteilhaft eine präzisere Bestimmung abweichender Leistungsaufnahmen.

Besonders bevorzugt werden die weiteren Daten im erfindungsgemäßen Verfahren genutzt, um die Mehrzahl von Fahrzeugen in Untergruppen zu unterteilen. Diese Untergruppen können dabei beispielsweise Modellvariationen eines Fahrzeugtyps aber auch Umgebungs- oder Betriebsbedingungen (siehe unten) abbilden. Gemäß dieser bevorzugten Durchführungsform erfolgt ferner ein Auslesen der Daten zur Leistungsaufnahme einer Fahrzeugkomponente ausschließlich aus einer Mehrzahl empfangener Datensätze einer Untergruppe. Somit erfolgt wiederum eine Beschränkung der im erfindungsgemäßen Verfahren verwendeten Datenbasis, gemäß dieser Durchführungsform jedoch mittels einer Unterteilung in Fahrzeuguntergruppen. Alternativ oder zusätzlich erfolgt im erfindungsgemäßen Verfahren anhand der weiteren Daten eine Plausibilisierung der abweichenden Leistungsaufnahme. Dabei wird in Reaktion auf eine abweichende aber plausibilisierte Leistungsaufnahme keine Fehlermeldung ausgegeben.

Wie bereits obenstehend ausgeführt, kann es sich bei den weiteren Daten beispielsweise um eine bestimmte Bauteilnummer und/oder Chargennummer einer Fahrzeugkomponente handeln. Bevorzugt werden somit Untergruppen von Fahrzeugen gebildet, in denen die jeweilige Fahrzeugkomponente mit der bestimmten Bauteilnummer und/oder Chargennummer verbaut ist und werden die Daten zur Leistungsaufnahme nur aus Datensätzen dieser Untergruppe ausgelesen. Alternativ oder zusätzlich wird bei einer abweichenden Leistungsaufnahme geprüft, ob diese zu einer Fahrzeugkomponente mit abweichender Bauteilnummer und/oder Chargennummer korrespondiert. Ist dies der Fall wird keine Fehlermeldung ausgegeben.

Ebenfalls bevorzugt handelt es sich bei den weiteren Daten um eine geografische Position der Fahrzeuge. Vorteilhaft können somit Untergruppen von Fahrzeugen gebildet werden, die sich in lokal begrenzten Bereichen aufhalten. Somit ist eine Annahme gleicher auf die Fahrzeugkomponenten wirkender Umweltbedingungen vorteilhaft zutreffender. Alternativ oder zusätzlich handelt es sich bei den weiteren Daten um meteorologische Daten wie beispielsweise eine Außentemperatur, einen Luftdruck und/oder eine relative Luftfeuchte. Es handelt sich somit um zur geografischen Position korrespondierende weitere Daten. Diese weiteren Daten können beispielsweise zur Plausibilisierung der Leistungsaufnahme von Heizelementen eines Fahrzeugs, wie beispielsweise einer Heckscheibenheizung, eingesetzt werden, indem davon ausgegangen wird, dass eine Leistungsaufnahme der Heizung bei niedrigeren Temperaturen deren Leistungsaufnahme bei höheren Temperaturen übersteigt.

Alternativ oder zusätzlich handelt es sich bei den weiteren Daten bevorzugt um eine Passagieranzahl und/oder eine Zuladung der Fahrzeuge. Die Passagieranzahl ist beispielsweise hinsichtlich der Leistungsaufnahme einer Klimaanlage mit Zonenautomatik relevant und kann diesbezüglich zur Bildung von Untergruppen beziehungsweise zur Plausibilisierung von abweichenden Leistungsaufnahmen genutzt werden. Die Zuladung kann beispielsweise zur Plausibilisierung von Daten zum Fahrzeugverbrauch oder zur Eintauchtiefe von Stoßdämpfern genutzt werden. Ebenfalls bevorzugt handelt es sich bei den weiteren Daten um eine Betriebsdauer des Fahrzeugs, entweder insgesamt oder während einer aktuellen Fahrt. Die Betriebsdauer kann hinsichtlich bestimmter Fahrzeugkomponenten, beispielsweise hinsichtlich einer Abgasreinigung, ebenfalls zur Bildung von Untergruppen oder zur Plausibilisierung herangezogen werden. Ebenfalls bevorzugt handelt es sich bei den weiteren Informationen um einen Fehlerstatus der Fahrzeuge. Somit kann vorteilhaft verhindert werden, dass eine dem Fahrer bereits bekannte Fehlermeldung häufig wiederholt ausgegeben wird.

Die in dem erfindungsgemäßen Verfahren ausgegebene Fehlermeldung zur abweichenden Leistungsaufnahme der bestimmten Fahrzeugkomponente wird vorzugsweise an das zumindest eine Fahrzeug übermittelt, in dem die bestimmte Fahrzeugkomponente angeordnet ist. In dem Fahrzeug wird die Fehlermeldung ausgegeben, beispielsweise über einen Bildschirm eines Infotainmentsystems oder mittels einer Fehlerwarnleuchte. Ebenfalls bevorzugt bewirkt die von dem Fahrzeug empfangene Fehlermeldung die Abschaltung der Fahrzeugkomponente, zumindest insofern es sich nicht um eine kritische Fahrzeugkomponente handelt. Beispielsweise wird eine Heckscheibenheizung abgeschaltet, sofern im erfindungsgemäßen Verfahren eine vom Schwarm abweichende Leistungsaufnahme derselben ermittelt wurde.

Alternativ oder zusätzlich wird die Fehlermeldung im erfindungsgemäßen Verfahren bevorzugt an ein mobiles Endgerät eines Nutzers des zumindest einen Fahrzeugs ausgegeben. Dies ist insbesondere bei auch im Stand beziehungsweise während des Parkens des Fahrzeugs aktiven Fahrzeugkomponenten sinnvoll, wie beispielsweise der Laderegelung oder der Standklimatisierung der Fahrzeuge. Somit kann beispielsweise ein Nutzer, der eine Klimatisierung für ein im Fahrzeug verbliebendes Haustier aktiviert hat, über eine Fehlfunktion der Klimaanlage informiert werden. Ebenfalls bevorzugt wird die Fehlermeldung an einen Servicepartner des Betreibers des Netzwerkservers übermittelt. Somit steht die Information zur abweichenden Leistungsaufnahme der Fahrzeugkomponente dem Betreiber des Netzwerkservers oder dessen Servicepartner ferner für eine prädikative Wartung *(predictive maintenance)* zur Verfügung. Dabei wird auf gehäuft auftretende unzulässige beziehungsweise unsichere Betriebszustände von Fahrzeugkomponenten in verschiedenen Fahrzeugen durch eine konzertierte Aktion reagiert, beispielsweise durch einen Wartungsaufruf oder Rückruf.

Ein weiterer Aspekt der vorliegenden Erfindung betrifft einen Netzwerkserver, beispielsweise einen Netzwerkserver eines Fahrzeugherstellers oder eines Servicepartners. Der erfindungsgemäße Netzwerkserver weist ein zur Datenkommunikation mit einer Mehrzahl von Fahrzeugen und/oder mobilen Endgeräten eingerichtetes (zweites) Kommunikationsmodul und eine (zweite) Steuereinheit auf. Dabei ist die (zweite) Steuereinheit des Netzwerkservers dafür eingerichtet, das erfindungsgemäße Verfahren durchzuführen. Die zweite Steuereinheit ist insbesondere dazu ausgebildet, die Leistungsaufnahme von Fahrzeugkomponenten betreffende Datensätze von einer Mehrzahl von Fahrzeugen zu empfangen, Daten zur Leistungsaufnahme einer Fahrzeugkomponente aus einer Mehrzahl der empfangenen Datensätze auszulesen, eine abweichende Leistungsaufnahme der Fahrzeugkomponente in zumindest einem Fahrzeug basierend auf den ausgelesen Daten zu ermitteln, und eine Fehlermeldung bezüglich der Fahrzeugkomponente in zumindest einem Fahrzeug auszugeben.

Ein weiterer Aspekt der Erfindung betrifft ein Computerprogramm, umfassend Befehle, die bei der Ausführung des Programms durch einen Computer, wie beispielsweise eine Steuereinheit eines Netzwerkservers, diesen veranlassen, die Schritte des Fahrzeugs im erfindungsgemäßen Verfahren durchzuführen, insbesondere die Schritte: Empfangen von die Leistungsaufnahme von Fahrzeugkomponenten betreffenden Datensätzen von einer Mehrzahl von Fahrzeugen; Auslesen der Daten zur Leistungsaufnahme einer Fahrzeugkomponente aus einer Mehrzahl der empfangenen Datensätze; Ermitteln einer abweichenden Leistungsaufnahme der Fahrzeugkomponente in zumindest einem Fahrzeug basierend auf den ausgelesen Daten; und Ausgabe einer Fehlermeldung zu der Fahrzeugkomponente des zumindest einen Fahrzeugs.

Ein weiterer Aspekt der Erfindung betrifft ein Fahrzeug, insbesondere einen zum Durchführen der Schritte eines Fahrzeugs im erfindungsgemäßen Verfahren eingerichteten Personenkraftwagen mit Verbrennungs-, Elektro- oder Hybridmotor. Das Fahrzeug weist eine zur elektrischen Versorgung von zumindest einer Fahrzeugkomponente eingerichtete Stromverteilereinheit (ePDU) und ein zur Kommunikation mit einem Netzwerkserver und einer Ladestation eingerichtetes (erstes) Kommunikationsmodul auf.

Die Stromverteilereinheit ist zwischen eine Energiequelle, beispielsweise ein Batteriesystem, und zumindest eine Fahrzeugkomponente geschaltet. Die Stromverteilereinheit weist dazu bevorzugt einen mit der Energiequelle verbundenen Eingang und eine Mehrzahl mit den Fahrzeugkomponenten verbundener Ausgänge auf. Die Stromverteilereinheit steuert die Leistungsverteilung auf die verschiedenen Ausgänge mit einer Mehrzahl von Halbleiterschaltern, insbesondere aus Leistungstransistoren gebildeten Halbleiterschaltern. Die Stromverteilereinheit ist somit zur Realisierung von Schalt- und Relaisfunktionen ausgebildet. Die Stromverteilereinheit ist ferner dazu ausgebildet, für jeden Ausgang die diesem Ausgang zugewiesene Spannung und den diesem Ausgang zugewiesenen Strom zu messen. Die Stromverteilereinheit ist ferner dazu ausgebildet, die Strom- und Spannungsmesswerte an eine Steuereinheit zur Ermittlung der Leistungsaufnahme der an die Ausgänge angeschlossenen Fahrzeugkomponenten zu übermitteln. Alternativ ist die Stromverteilereinheit selbst zum Ermitteln der Leistungsaufnahme der einzelnen Fahrzeugkomponenten ausgebildet.

Das Fahrzeug weist ferner eine Steuereinheit auf, die dafür eingerichtet ist, mittels der Stromverteilereinheit die Leistungsaufnahme von Fahrzeugkomponenten betreffende Daten zu erfassen und mittels des Kommunikationsmoduls Datensätze der erfassten Daten an einen Netzwerkserver zu übermitteln. Die Steuereinheit ist ferner dazu ausgebildet, mittels des Kommunikationsmoduls eine Fehlermeldung eines Netzwerkservers zu einer abweichenden Leistungsaufnahme zumindest einer Fahrzeugkomponente des Fahrzeugs zu empfangen. Die Steuereinheit ist ferner dazu ausgebildet, in Reaktion auf die empfangene Fehlermeldung, ein Ausgabemittel des Fahrzeugs zum Ausgeben einer Fehlermeldung anzusteuern und/oder die in der Fehlermeldung adressierte Fahrzeugkomponente abzuschalten.

Ein weiterer Aspekt der Erfindung betrifft ein Verfahren einer Steuereinheit eines Fahrzeugs, welches eine zur elektrischen Versorgung von zumindest einer Fahrzeugkomponente eingerichtete Stromverteilereinheit (ePDU), ein zur Kommunikation mit einem Netzwerkserver und einer Ladestation eingerichtetes (erstes) Kommunikationsmodul und eine Steuereinheit aufweist, wobei das Verfahren zumindest die Schritte Erfassen einer Leistungsaufnahme von zumindest einer Fahrzeugkomponente betreffende Daten mittels der Stromverteilereinheit, Übermitteln von Datensätzen der erfassten Daten an einen Netzwerkserver und Empfangen einer Fehlermeldung eines Netzwerkservers zu einer abweichenden Leistungsaufnahme zumindest einer Fahrzeugkomponente des Fahrzeugs. Bevorzugt weist das Verfahren ferner die Schritte Ausgeben einer Fehlermeldung und/oder Abschalten der in der Fehlermeldung adressierten Fahrzeugkomponente auf. Ein weiterer Aspekt der Erfindung betrifft ein Computerprogramm, umfassend Befehle, die bei der Ausführung des Programms durch einen Computer, wie beispielsweise eine Steuereinheit eines Fahrzeugs, diesen veranlassen, die vorgenannten Schritte des Fahrzeugs im erfindungsgemäßen Verfahren durchzuführen.

Ein weiterer Aspekt der vorliegenden Erfindung betrifft ein System aus einem erfindungsgemäßen Netzwerkserver, wie obenstehend beschrieben, und einem Fahrzeug, wie obenstehend beschrieben. Vorteilhaft können alle Verfahrensschritte und Aspekte des erfindungsgemäßen Verfahrens in dem erfindungsgemäßen System verwirklicht werden.

Die Verfahrensschritte des erfindungsgemäßen Verfahrens können durch elektrische oder elektronische Bauteile oder Komponenten (Hardware), durch Firmware (ASIC) implementiert sein oder durch beim Ausführen eines geeigneten Programms (Software) verwirklicht werden. Ebenfalls bevorzugt wird das erfindungsgemäße Verfahren durch eine Kombination von Hardware, Firmware und/oder Software verwirklicht, beziehungsweise implementiert. Beispielsweise sind einzelne Komponenten zum Durchführen einzelner Verfahrensschritte als separat integrierter Schaltkreis ausgebildet oder auf einem gemeinsamen integrierten Schaltkreis angeordnet. Einzelne zum Durchführen einzelner Verfahrensschritte eingerichtete Komponenten sind ferner bevorzugt auf einem (flexiblen) gedruckten Schaltungsträger (FPCB/PCB), einem Tape Carrier Package (TCP) oder einem anderen Substrat angeordnet.

Die einzelnen Verfahrensschritte des erfindungsgemäßen Verfahrens sind ferner bevorzugt als ein oder mehrere Prozesse ausgebildet, die auf einem oder mehreren Prozessoren in einem oder mehreren elektronischen Rechengeräten laufen und beim Ausführen von einem oder mehreren Computerprogrammen erzeugt werden. Die Rechengeräte sind dabei bevorzugt dazu ausgebildet, mit anderen Komponenten, beispielsweise einem Kommunikationsmodul, und gegebenenfalls einem oder mehreren Sensoren zusammenzuarbeiten, um die hierin beschriebenen Funktionalitäten zu verwirklichen. Die Anweisungen der Computerprogramme sind dabei bevorzugt in einem Speicher abgelegt, wie beispielsweise einem RAM-Element. Die Computerprogramme können jedoch auch in einem nicht-flüchtigen Speichermedium, wie beispielsweise einer CD-ROM, einem Flash-Speicher oder dergleichen abgelegt sein.

Dem Fachmann ist ferner ersichtlich, dass die Funktionalitäten von mehreren Computern (Datenverarbeitungsgeräten) kombiniert oder in einem einzigen Gerät kombiniert sein können oder dass die Funktionalität von einem bestimmten Datenverarbeitungsgerät auf einer Vielzahl von Geräten verteilt vorliegen kann, um die Schritte des erfindungsgemäßen Verfahrens auszuführen, ohne von dem erfindungsgemäßen Verfahren abzuweichen.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:
- Figur 1: eine schematische Darstellung eines erfindungsgemäßen Systems aus einem erfindungsgemäßen Netzwerkserver und einer Mehrzahl von Fahrzeugen gemäß einer Ausführungsform; und
- Figur 2: ein Ablaufdiagramm eines im erfindungsgemäßen System durchgeführten erfindungsgemäßen Verfahrens gemäß einer Durchführungsform.

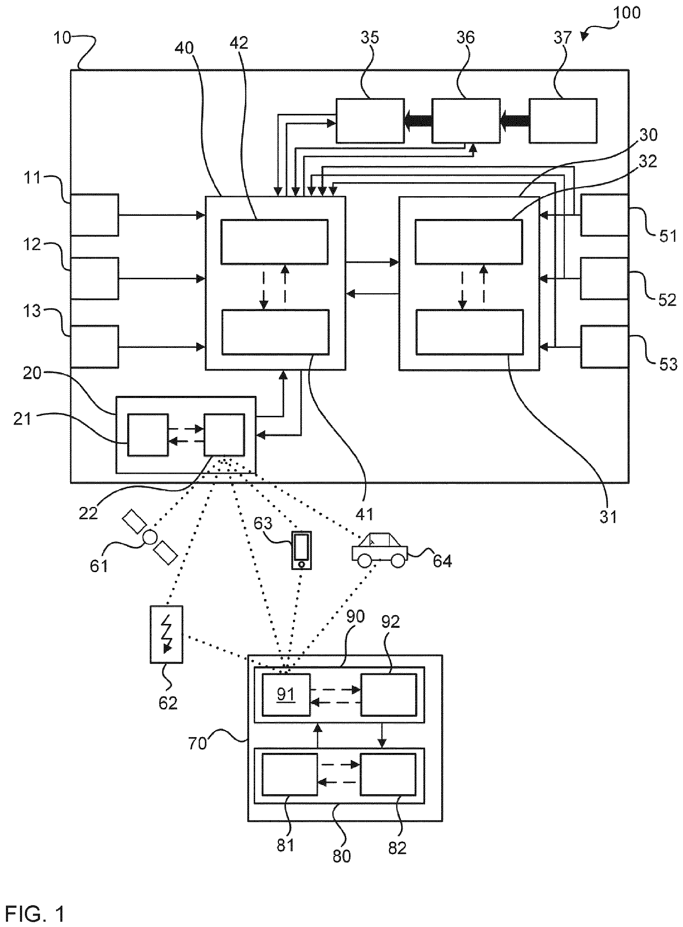

Figur 1 zeigt eine schematische Darstellung eines erfindungsgemäßen Systems 100 aus einer Mehrzahl gleichartiger Fahrzeuge 10, 64, die jeweils mit einem erfindungsgemäßen Netzwerkserver 70 kommunizieren. Das Bezugszeichen 10 bezeichnet in Figur 1 ein Blockdiagramm eines beispielhaften Fahrzeugs 10, insbesondere eines zweispurigen Fahrzeugs mit Verbrennungs-, Elektro- oder Hybridmotor. Das Fahrzeug 10 umfasst eine Vielzahl erster Sensoren, insbesondere einen ersten Sensor 11, einen zweiten Sensor 12 und einen dritten Sensor 13. Die ersten Sensoren 11, 12, 13 sind eingerichtet zum Erfassen von Umgebungsdaten des Fahrzeugs 10 und umfassen beispielsweise eine Kamera zum Erfassen eines Bildes einer das Fahrzeug 10 unmittelbar umgebenden Umwelt, Abstandssensoren, wie beispielsweise Ultraschallsensoren oder LIDAR, zum Erfassen von Abständen zu das Fahrzeug 10 umgebenden Objekten. Die ersten Sensoren 11, 12, 13 übertragen die von ihnen erfassten Umgebungssignale an eine erste Steuereinheit 40 und ein Fahrsystem 30 des Fahrzeugs 10.

Das Fahrzeug 10 weist ferner eine Mehrzahl zweiter Sensoren, insbesondere einen vierten Sensor 51, einen fünften Sensor 52, und einen sechsten Sensor 53 auf. Bei den zweiten Sensoren 51, 52 ,53 handelt es sich um Sensoren zum Ermitteln von das Fahrzeug 10 selbst betreffenden Zustandsdaten, wie beispielsweise aktuelle Lage- und Bewegungsinformationen des Fahrzeugs. Bei den zweiten Sensoren handelt es sich folglich beispielsweise um Geschwindigkeitssensoren, Beschleunigungssensoren, Neigungssensoren, Sensoren zum Messen einer Eintauchtiefe eines Stoßdämpfers, Raddrehzahlsensoren oder dergleichen. Die zweiten Sensoren 51, 52, 53 übermitteln die von ihnen erfassten Zustandssignale an die erste Steuereinheit 40 des Fahrzeugs 10. Darüber hinaus übermitteln die zweiten Sensoren 51, 52, 53 ihre Messergebnisse unmittelbar an ein Fahrsystem 30 des Fahrzeugs 10.

Das Fahrzeug 10 weist ferner ein erstes Kommunikationsmodul 20 mit einem Speicher 21 und einem oder mehreren Transpondern beziehungsweise Sendeempfängern 22 auf. Bei den Transpondern 22 handelt es sich um einen Funk-, WLAN-, GPS- oder Bluetooth-Sendeempfänger oder dergleichen. Der Transponder 22 kommuniziert mit dem internen Speicher 21 des ersten Kommunikationsmoduls 20, beispielsweise über einen geeigneten Datenbus. Das erste Kommunikationsmodul 20 kommuniziert auch mit der ersten Steuereinheit 40. Darüber hinaus ist das erste Kommunikationsmodul 20 dafür eingerichtet, mit einem mobilen Netzwerkserver 70, insbesondere einem Backendserver eines Fahrzeugherstellers oder dessen Servicepartner zu kommunizieren. Das erste Kommunikationsmodul 20 ist ferner dafür eingerichtet, mit einem Fahrzeug 64 zu kommunizieren, das ebenso ausgebildet ist, wie das Fahrzeug 10. Das Kommunikationsmodul 20 ist ferner dafür eingerichtet, mit einem mobilen Endgerät 63, und mit einer elektrischen Ladestation 62 zu kommunizieren. Die Kommunikation erfolgt dabei insbesondere über eine Drahtlosschnittstelle, beispielsweise über WLAN, ein Mobilfunknetz (4G oder 5G) Fahrzeug-zu-Fahrzeug Kommunikation und dergleichen.

Das Fahrzeug 10 weist ferner das Fahrsystem 30 auf, das zum vollständig automatischen Fahrbetrieb, insbesondere zur Längs- und Querführung, des Fahrzeugs 10 eingerichtet ist. Das Fahrsystem 30 weist ein Navigationsmodul 32 auf, das zum Berechnen von Routen zwischen einem Start- und einem Zielpunkt und zum Ermitteln der entlang dieser Route vom Fahrzeug 10 durchzuführenden Manöver eingerichtet ist. Das Navigationsmodul 32 ist ferner bevorzugt zum Durchführen spezifischer Manöver des Fahrzeugs 10 ausgebildet, wie beispielsweise Einpark- und Ausparkmanöver. Darüber hinaus umfasst das Fahrsystem 30 einen internen Speicher 31, der mit dem Navigationsmodul 32 kommuniziert, beispielsweise über einen geeigneten Datenbus. Die Funktionalität des Fahrsystems 30 wird von der Steuereinheit 40 kontrolliert.

Das Fahrzeug 10 weist ferner eine erste Steuereinheit 40 auf, welche zum Durchführen der Schritte des Fahrzeugs 10 im erfindungsgemäßen Verfahren eingerichtet ist. Dabei führt die Steuereinheit 40 die Schritte selbst durch oder steuert die anderen Komponenten des Fahrzeugs 10 entsprechend an. Hierzu verfügt die erste Steuereinheit 40 über einen internen Speicher 41 und eine CPU 42, welche miteinander kommunizieren, beispielsweise über einen geeigneten Datenbus. Darüber hinaus steht die erste Steuereinheit 40 in Kommunikationsverbindung mit zumindest den ersten Sensoren 11, 12, 13, den zweiten Sensoren 51, 52, 53, dem ersten Kommunikationsmodul 20, dem Fahrsystem 30 und der Stromverteilereinheit 36, beispielsweise über eine oder mehrere jeweilige CAN-Verbindungen, eine oder mehrere jeweilige SPI-Verbindungen, oder andere geeignete Datenverbindungen.

Das Fahrzeug 10 weist ferner eine Heckscheibenheizung 35 auf, die gemäß dieser Ausführungsform als exemplarische Fahrzeugkomponente des erfindungsgemäßen Verfahrens erläutert wird. Die Heckscheibenheizung 35 wird von einem Energiespeicher 37 mit elektrischer Energie versorgt, wie durch die schwarzen Pfeile in Figur 1 angedeutet. Die Energieversorgung erfolgt dabei über eine Stromverteilereinheit (ePDU) 36, die in einem elektrischen Bordnetz zwischen dem Energiespeicher 37 und der Heckscheibenheizung angeordnet ist. Die Stromverteilereinheit 36 kommuniziert mit der Steuereinrichtung 40, insbesondere indem sie dieser Daten zur Leistungsaufnahme der Heckscheibenheizung 35 übermittelt. Die Funktion der Heckscheibenheizung 35 und der Stromverteilereinheit 36 erfolgt jeweils unter der Kontrolle der Steuereinheit 40, indem die Steuereinheit 40 dafür entsprechende Steuersignale an die Heckscheibenheizung 35 beziehungsweise die Stromverteilereinheit 36 übermittelt.

Der Netzwerkserver 70 weist eine zweite Steuereinheit 80 auf, welche zum Durchführen der Schritte des Netzwerkservers 70 im erfindungsgemäßen Verfahren eingerichtet ist. Hierzu verfügt die zweite Steuereinheit 80 über einen internen Speicher 81 und eine CPU 82, welche miteinander kommunizieren, beispielsweise über einen geeigneten Datenbus. Der Netzwerkserver 70 weist ferner ein zweites Kommunikationsmodul 90 auf. Das zweite Kommunikationsmodul 90 weist einen Speicher 92 und einen oder mehrere Transponder beziehungsweise Sendeempfänger 91 auf. Bei den Transpondern 91 handelt es sich um einen Funk-, WLAN-, GPS- oder Bluetooth-Sendeempfänger oder dergleichen. Der Transponder 91 kommuniziert mit dem internen Speicher 92 des zweiten Kommunikationsmoduls 90, beispielsweise über einen geeigneten Datenbus. Bevorzugt ist das zweite Kommunikationsmodul 90 dazu eingerichtet, über ein 4G/5G Mobilfunknetz zu kommunizieren.

Die Ladestation 62 und das mobile Endgerät 63 weisen jeweils ebenfalls ein drittes beziehungsweise viertes Kommunikationsmodul und eine dritte beziehungsweise vierte Steuereinheit auf und stehen in Kommunikationsverbindung mit dem Netzwerkserver 70 und dem Fahrzeug 10. Die Ladestation 62 weist ferner Mittel zum Laden des Energiespeichers 37 des elektrischen Fahrzeugs 10 auf. Die Ladestation 62 ist bevorzugt mit einer Energiequelle oder einem Energiespeicher, bevorzugt mit einem Stromnetz, verbunden.

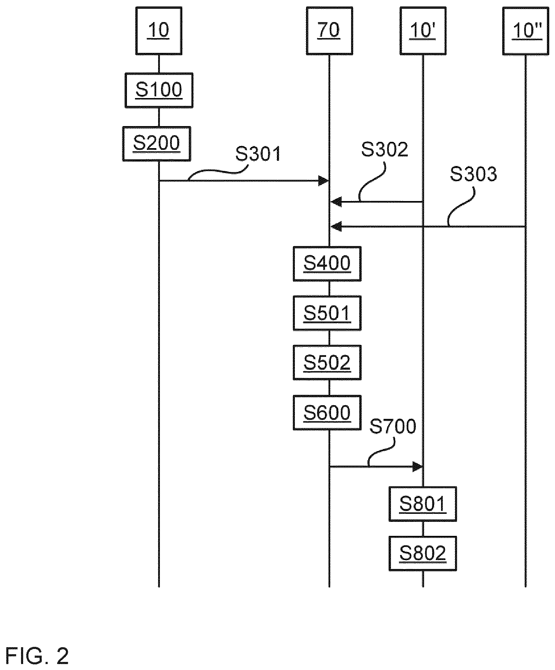

Figur 2 zeigt ein schematisches Ablaufdiagramm eines im erfindungsgemäßen System 100 durchgeführten erfindungsgemäßen Verfahrens gemäß einer Durchführungsform. Das System 100 umfasst dabei den Netzwerkserver 70 und mehrere gleichartige Fahrzeuge 10, 10', 10".

In einem ersten Schritt des erfindungsgemäßen Verfahrens erfasst eine Steuereinheit 40 des ersten Fahrzeugs 10 mittels der Stromverteilereinheit 36 Daten zur Leistungsaufnahme einer Heckscheibenheizung 35. Darüber hinaus erfasst die Steuereinheit 40 mittels der Stromverteilereinheit 36 gegebenenfalls weitere Daten zur Leistungsaufnahme anderer Fahrzeugkomponenten, auf die jedoch hier nicht weiter eingegangen werden soll. In einem Schritt S200 erzeugt das Fahrzeug 10 einen Datensatz aus allen die Leistungsaufnahme von Fahrzeugkomponenten betreffenden Daten und sendet den Datensatz in Schritt S301 mittels des Kommunikationsmoduls 20 an das Kommunikationsmodul 91 des Netzwerkservers 70.

Der Netzwerkserver 70 empfängt mittels seines Kommunikationsmoduls 91 in den Schritten S302 und S303 darüber hinaus die Leistungsaufnahme von Fahrzeugkomponenten betreffende Datensätze von den Fahrzeugen 10' und 10". Darüber hinaus empfängt der Netzwerkserver 70 in den Schritten S301, 302, 303 weitere Daten zu den Positionen der Fahrzeuge 10, 10', 10" und zu den Bauteilenummern der in den Fahrzeugen 10, 10', 10" verbauten Komponenten. Darüber hinaus empfängt der Netzwerkserver 70 gegebenenfalls Daten zur Leistungsaufnahme von Fahrzeugkomponenten und weitere Daten von anderen Fahrzeugen.

In dem Schritt S400 ermittelt der Netzwerkserver 70 anhand der weiteren Daten, insbesondere den Bauteilenummern, dass in jedem der Fahrzeuge 10, 10', 10" eine baugleiche Heckscheibenheizung 35 verbaut ist. Basierend darauf liest der Netzwerkserver in Schritt S501 Daten zur Leistungsaufnahme der Heckscheibenheizung 35 aus jedem der von den Fahrzeugen 10, 10', 10" empfangenen Datensätze aus und ermittelt basierend darauf eine abweichende Leistungsaufnahme der Heckscheibenheizung 35' des Fahrzeugs 10'. Dabei prüft der Netzwerkserver 70 zunächst die Positionen der Fahrzeuge 10, 10', 10" und ruft zu diesen Positionen meteorologische Information ab. Diese meteorologischen Informationen zeigen an, dass sich die Umgebungsbedingungen der Fahrzeuge 10, 10', 10" wenig unterscheiden. Da die Leistungsaufnahmen der Heckscheibenheizungen 35, 35" der Fahrzeuge 10, 10" nahezu identisch sind und die Leistungsaufnahme der Heckscheibenheizung 35' des Fahrzeugs 10' trotz ähnlicher Umgebungsbedingungen nahezu verdoppelt ist, ermittelt der Netzwerkserver 70 die abweichende Leistungsaufnahme der Heckscheibenheizung 35' des Fahrzeugs 10'.

In dem Schritt S700 übermittelt der Netzwerkserver 70 eine Fehlermeldung betreffend die abweichende Leistungsaufnahme der Heckscheibenheizung 35' an das Fahrzeug 10', insbesondere an dessen Steuereinheit 40' mittels dessen Kommunikationsmoduls 20'. Die Steuereinheit 10' des Fahrzeugs gibt in Schritt S801 die empfangene oder eine ähnliche Fehlermeldung zum Defekt der Heckscheibenheizung 35' über einen Bildschirm aus und fordert den Nutzer zum Besuch einer Werkstatt auf. Zudem schaltet die Steuereinheit 10' in Schritt S802 die Heckscheibenheizung 35' ab und setzt eine Flag, die ein Wiedereinschalten durch den Nutzer verhindert und nur durch eine Vertragswerkstatt des Herstellers entfernt werden kann.

### Bezugszeichenliste

- 10: Fahrzeug
- 11: erster Sensor
- 12: zweiter Sensor
- 13: dritter Sensor
- 20: Kommunikationsmodul
- 21: Speicher
- 22: Transponder
- 30: Fahrsystem
- 31: Speicher
- 32: Navigationsmodul
- 35: Heckscheibenheizung
- 36: Stromverteilereinheit
- 37: elektrischer Energiespeicher (Batteriesystem)
- 40: Steuereinheit
- 41: Speicher
- 42: CPU
- 51: vierter Sensor
- 52: fünfter Sensor
- 53: sechster Sensor
- 61: Satellit
- 62: Ladestation
- 63: mobiles Endgerät (Smartphone)
- 70: Netzwerkserver
- 80: Steuereinheit
- 81: Speicher
- 82: CPU
- 90: Kommunikationsmodul
- 91: Transponder
- 92: Speicher
- 100: System

## Patentansprüche

1. Verfahren eines Netzwerkservers (70) zum Warten von Fahrzeugkomponenten (35), das Verfahren aufweisend die Verfahrensschritte:
Empfangen von die Leistungsaufnahme der Fahrzeugkomponenten (35) betreffenden Datensätzen von einer Mehrzahl von Fahrzeugen (10, 64);
Auslesen der Daten zur Leistungsaufnahme einer Fahrzeugkomponente (35) aus einer Mehrzahl der empfangenen Datensätze;
Ermitteln einer abweichenden Leistungsaufnahme der Fahrzeugkomponente (35) in zumindest einem Fahrzeug (10) basierend auf den ausgelesenen Daten, wobei anhand der Informationen zur Leistungsaufnahme der gleichen Fahrzeugkomponente in verschiedenen Fahrzeugen zumindest eine Leistungsaufnahme ermittelt wird, die auf unzulässige Weise von den anderen Leistungsaufnahmen der gleichen Fahrzeugkomponente (35) abweicht; und
Ausgabe einer Fehlermeldung bezüglich der Fahrzeugkomponente (35) in dem zumindest einen Fahrzeug (10).

2. Verfahren nach Anspruch 1, wobei jeder Datensatz auf Daten zumindest einer in einem der Fahrzeuge (10) verbauten Stromverteilereinheit (36) basiert.

3. Verfahren nach Anspruch 1 oder 2, ferner aufweisend den Verfahrensschritt:
Ermitteln einer mittleren Leistungsaufnahme der bestimmten Fahrzeugkomponente (35) anhand der ausgelesenen Daten; und
Ermitteln einer abweichenden Leistungsaufnahme, welche von der mittleren Leistungsaufnahme um mehr als einen vorbestimmten Grenzwert abweicht.

4. Verfahren nach einem der vorangehenden Ansprüche, wobei das Auslesen der Daten zur Leistungsaufnahme einer Fahrzeugkomponente (35) aus von Fahrzeugen (10) eines gleichen Fahrzeugtyps empfangenen Datensätzen erfolgt.

5. Verfahren nach einem der vorangehenden Ansprüche, wobei die abweichende Leistungsaufnahme der Fahrzeugkomponente (35) in dem zumindest einen Fahrzeug (10) zusätzlich anhand weiterer Daten ermittelt wird.

6. Verfahren nach Anspruch 5, ferner aufweisend die Verfahrensschritte:
Unterteilen der Mehrzahl von Fahrzeugen (10) anhand der weiteren Daten in Untergruppen, und
Auslesen der Daten zur Leistungsaufnahme einer Fahrzeugkomponente (35) aus einer Mehrzahl empfangener Datensätze einer Untergruppe; und/oder
Plausibilisierung der abweichenden Leistungsaufnahme anhand der weiteren Daten.

7. Verfahren nach Anspruch 5 oder 6, wobei die weiteren Daten beispielsweise eine Position, eine Außentemperatur, eine Passagieranzahl, eine Betriebsdauer, einen Fehlerstatus und/oder eine Zuladung der Fahrzeuge (10) betreffen.

8. Verfahren nach einem der vorangehenden Ansprüche, wobei die Fehlermeldung:
an das zumindest eine Fahrzeug (10) übermittelt wird und in dem Fahrzeug (10) ausgegeben wird und/oder die Abschaltung der Fahrzeugkomponente (35) bewirkt;
an ein mobiles Endgerät eines Nutzers des zumindest einen Fahrzeugs (10) ausgegeben wird; und/oder
an einen Servicepartner des Betreibers des Netzwerkservers (70) übermittelt wird.

9. Netzwerkserver (70), aufweisend ein zur Datenkommunikation mit einer Mehrzahl von Fahrzeugen (10) eingerichtetes Kommunikationsmodul (90) und eine zum Durchführen eines Verfahrens nach den Ansprüchen 1 bis 7 eingerichtete Steuereinheit (80).

10. Fahrzeug (10), aufweisend eine zur elektrischen Versorgung von zumindest einer Fahrzeugkomponente (35) eingerichtete Stromverteilereinheit (36); ein zur Kommunikation mit einem Netzwerkserver (70) eingerichtetes Kommunikationsmodul (20); und eine Steuereinheit (40),
wobei die Steuereinheit dafür eingerichtet ist:
mittels der Stromverteilereinheit (36) die Leistungsaufnahme von Fahrzeugkomponenten (35) betreffende Daten zu erfassen;
mittels des Kommunikationsmoduls (20) Datensätze der erfassten Daten an einen Netzwerkserver (70) gemäß Anspruch 9 zu übermitteln.

## Claims

1. Method of a network server (70) for maintaining vehicle components (35), the method comprising the method steps of:
receiving data sets relating to the power consumption of the vehicle components (35) from a plurality of vehicles (10, 64);
reading the power consumption data of a vehicle component (35) from a plurality of the received data sets;
determining a deviating power consumption of the vehicle component (35) in at least one vehicle (10) on the basis of the read-out data, wherein, using the information on the power consumption of the same vehicle component in different vehicles, at least one power consumption is determined which deviates impermissibly from the other power consumptions of the same vehicle component (35); and
output of an error message regarding the vehicle component (35) in the at least one vehicle (10).

2. Method according to claim 1, wherein each data set is based on data from at least one power distribution unit (36) installed in one of the vehicles (10).

3. Method according to either claim 1 or claim 2, further comprising the method step of:
determining the average power consumption of the specific vehicle component (35) on the basis of the read-out data; and
determining a deviating power consumption that deviates from the average power consumption by more than a predetermined limit.

4. Method according to any of the preceding claims, wherein the data on the power consumption of a vehicle component (35) is read from data sets received from vehicles (10) of the same vehicle type.

5. Method according to any of the preceding claims, wherein the deviating power consumption of the vehicle component (35) in the at least one vehicle (10) is additionally determined on the basis of further data.

6. Method according to claim 5, further comprising the method steps of:
subdividing the majority of vehicles (10) into subgroups on the basis of the additional data, and
reading the power consumption data of a vehicle component (35) from a plurality of received data sets of a subgroup; and/or
plausibility check of the deviating power consumption on the basis of the additional data.

7. Method according to either claim 5 or claim 6, wherein the additional data relate to, for example, a position, an outside temperature, a number of passengers, an operating time, an error status and/or a payload of the vehicles (10).

8. Method according to any of the preceding claims, wherein the error message:
is transmitted to the at least one vehicle (10) and is output in the vehicle (10) and/or causes the vehicle component (35) to be switched off;
is output to a mobile device of a user of the at least one vehicle (10); and/or
is transmitted to a service partner of the operator of the network server (70).

9. Network server (70) comprising a communication module (90) configured for data communication with a plurality of vehicles (10) and a control unit (80) configured for carrying out a method according to claims 1 to 7.

10. Vehicle (10) comprising a power distribution unit (36) configured for the electrical supply of at least one vehicle component (35); a communication module (20) configured for communication with a network server (70); and a control unit (40),
wherein the control unit is configured:
to record data relating to the power consumption of vehicle components (35) by means of the power distribution unit (36);
to transmit data sets of the recorded data to a network server (70) according to claim 9 by means of the communication module (20).

## Revendications

1. Procédé pour un serveur de réseau (70) permettant l'entretien de composants de véhicule (35), le procédé présentant les étapes de procédé consistant à :
recevoir, d'une pluralité de véhicules (10, 64), des ensembles de données concernant la puissance absorbée des composants de véhicule (35) ;
extraire les données relatives à la puissance absorbée d'un composant de véhicule (35) parmi les ensembles de données reçus ;
déterminer une puissance absorbée divergente du composant de véhicule (35) dans au moins un véhicule (10) sur la base des données extraites, dans lequel, à l'aide des informations relatives à la puissance absorbée du même composant de véhicule dans différents véhicules, au moins une puissance absorbée est déterminée, laquelle diverge de manière inadmissible des autres puissances absorbées du même composant de véhicule (35) ; et
délivrer en sortie un message d'erreur quant au composant de véhicule (35) dans l'au moins un véhicule (10).

2. Procédé selon la revendication 1, dans lequel chaque ensemble de données se base sur des données d'au moins une unité de distribution électrique (36) montée dans l'un des véhicules (10).

3. Procédé selon la revendication 1 ou 2, présentant en outre l'étape de procédé consistant à :
déterminer une puissance absorbée moyenne du composant de véhicule (35) défini à l'aide des données extraites ; et
déterminer une puissance absorbée divergente qui diverge de plus d'une valeur limite prédéfinie de la puissance absorbée moyenne.

4. Procédé selon l'une des revendications précédentes, dans lequel l'extraction des données relatives à la puissance absorbée d'un composant de véhicule (35) est effectuée à partir d'ensembles de données reçus de véhicules (10) d'un même type de véhicule.

5. Procédé selon l'une des revendications précédentes, dans lequel la puissance absorbée divergente du composant de véhicule (35) dans l'au moins un véhicule (10) est en outre déterminée à l'aide de données supplémentaires.

6. Procédé selon la revendication 5, présentant en outre les étapes de procédé consistant à :
répartir la pluralité de véhicules (10) en sous-groupes à l'aide des données supplémentaires, et
extraire les données relatives à la puissance absorbée d'un composant de véhicule (35) d'une pluralité d'ensembles de données reçus d'un sous-groupe ; et/ou
contrôler la plausibilité de la puissance absorbée divergente à l'aide des données supplémentaires.

7. Procédé selon la revendication 5 ou 6, dans lequel les données supplémentaires concernent, par exemple, une position, une température extérieure, un nombre de passagers, une durée de fonctionnement, un état d'erreur et/ou une charge utile des véhicules (10).

8. Procédé selon l'une des revendications précédentes, dans lequel le message d'erreur :
est transmis à l'au moins un véhicule (10) et est délivré en sortie dans le véhicule (10) et/ou provoque la mise hors service du composant de véhicule (35) ;
est délivré en sortie à un terminal mobile d'un utilisateur de l'au moins un véhicule (10) ; et/ou
est transmis à un partenaire de service de l'exploitant du serveur de réseau (70).

9. Serveur de réseau (70), présentant un module de communication (90) configuré pour communiquer des données avec une pluralité de véhicules (10) et une unité de commande (80) configurée pour mettre en œuvre un procédé selon les revendications 1 à 7.

10. Véhicule (10), présentant une unité de distribution électrique (36) configurée pour alimenter en électricité au moins un composant de véhicule (35) ; un module de communication (20) configuré pour communiquer avec un serveur de réseau (70) ; et une unité de commande (40),
dans lequel l'unité de commande est configurée pour :
collecter, au moyen de l'unité de distribution électrique (36), les données concernant la puissance absorbée des composants de véhicule (35) ;
transmettre, au moyen du module de communication (20), des ensembles de données des données collectées à un serveur de réseau (70), conformément à la revendication 9.
